# DEMANDE DE BREVET EUROPEEN

(11) **EP 3 502 549 A1**
(43) Date de publication de la demande: **26.06.2019**
(21) Numéro de dépôt: 18213886.7
(22) Date de dépôt: 19.12.2018
(51) Int. Cl.: F21S 41/143, F21S 41/155, H01L 33/08, H01L 33/18, F21W 102/135, F21Y 105/12, F21Y 105/14

(54) **MODULE LUMINEUX À ÉLÉMENTS ÉLECTROLUMINESCENTS À COUPURE PROGRESSIVE**

(30) Priorité: 22.12.2017 FR 1763083
(71) Demandeur: Valeo Vision, 93012 Bobigny Cedex (FR)
(72) Inventeur: ALBOU, Pierre, 93012 BOBIGNY Cedex (FR); GODBILLON, Vincent, 93012 BOBIGNY Cedex (FR); PUENTE, Jean-Claude, 93012 BOBIGNY Cedex (FR)
(74) Mandataire: Valeo Vision

(57) **Abrégé**

L'invention concerne un module d'émission lumineuse (400) d'un dispositif d'éclairage/signalisation, notamment pour véhicule automobile, comprenant :
- au moins une source lumineuse (401) comprenant un ensemble d'éléments électroluminescents de dimensions submillimétriques ;
les éléments électroluminescents étant répartis dans une première zone et dans une deuxième zone de manière à ce que la première zone émette une première intensité lumineuse et à ce que la deuxième zone assure une transition entre la première intensité lumineuse à proximité de la première zone, et une deuxième intensité lumineuse inférieure à la première intensité lumineuse.

## Description

La présente demande concerne le domaine des modules lumineux et en particulier pour l'éclairage/la signalisation dans un véhicule automobile.

On entend par module lumineux tout dispositif apte à émettre de la lumière, notamment pour l'éclairage et/ou la signalisation dans le véhicule automobile.

Un tel module lumineux intègre à cet effet une source de lumière. Les sources de lumière utilisées pour l'éclairage et la signalisation dans les véhicules automobiles sont de plus en plus fréquemment constituées par des diodes électroluminescentes, notamment pour des avantages d'encombrement et d'autonomie par rapport à des sources de lumière classiques. L'utilisation de diodes électroluminescentes dans les modules d'éclairage et/ou de signalisation a permis en outre aux acteurs du marché (fabricant d'automobiles et concepteur de dispositifs d'éclairage et/ou de signalisation) d'apporter une touche créative à la conception de ces dispositifs, notamment pour l'utilisation d'un nombre toujours plus grand de ces diodes électroluminescentes pour réaliser des effets optiques.

La source lumineuse peut présenter deux ensembles distincts de diodes électroluminescentes, chaque ensemble étant compris dans une zone donnée de la source, les deux zones étant séparées par une coupure.

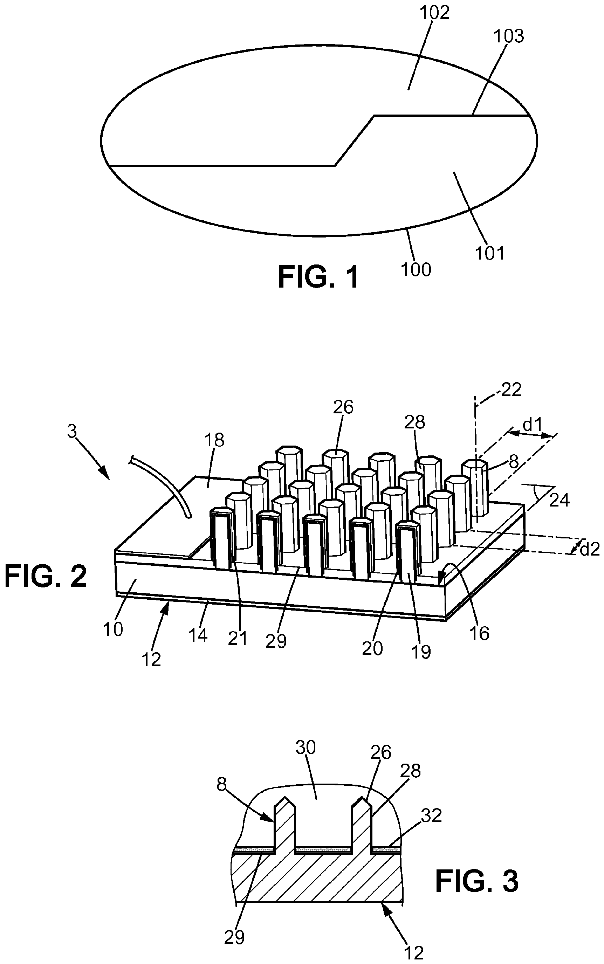

En référence à la figure 1, il est représenté deux zones 101 et 102 d'une source lumineuse 100, selon l'art antérieur, les zones 101 et 102 étant séparées par une coupure 103, pour un éclairage dans une direction perpendiculaire au plan de la figure 1.

Les zones 101 et 102 sont adressables individuellement afin de pouvoir remplir plusieurs fonctions lumineuses en utilisant la même source.

A titre d'exemple, la source lumineuse 100 peut remplir :
- une fonction feu de croisement, ou « low beam », lorsque seule la ou les diodes de la zone 101 sont allumées, les diodes de la zone 102 étant éteintes ;
- une fonction feu de route, ou « high beam » en anglais, lorsque les diodes des zones 101 et 102 sont allumées.

Toutefois, des contraintes réglementaires tendent à imposer une coupure 103 plus ou moins nette entre les zones 101 et 102.

En particulier, une règlementation européenne impose un gradient de luminosité très élevé en cas de feu de croisement entre la zone 101 lumineuse et la zone 102 sombre, tandis qu'une réglementation américaine impose un gradient plus progressif entre les deux zones.

Il existe ainsi un besoin de réaliser une transition d'intensité lumineuse entre une zone sombre et une zone lumineuse dans le cadre d'une fonction lumineuse, telle qu'une fonction de type feu de croisement.

La présente invention vient améliorer la situation.

Un premier aspect de l'invention concerne un module d'émission lumineuse d'un dispositif d'éclairage/signalisation, notamment pour véhicule automobile, comprenant :
- au moins une source lumineuse comprenant un ensemble d'éléments électroluminescents de dimensions submillimétriques ;
les éléments électroluminescents étant répartis dans une première zone et dans une deuxième zone de manière à ce que la première zone émette une première intensité lumineuse et à ce que la deuxième zone assure une transition entre la première intensité lumineuse à proximité de la première zone, et une deuxième intensité lumineuse inférieure à la première intensité lumineuse.

Les éléments électroluminescents sont crus depuis un substrat commun et sont connectés électriquement de manière à être activables sélectivement, individuellement ou par sous-ensemble d'éléments émissifs. La configuration d'une telle source lumineuse dite monolithique permet l'agencement de pixels activables sélectivement très proches les uns des autres, par rapport aux diodes électroluminescentes classiques destinées à être soudés sur des plaques de circuits imprimés.

L'utilisation d'éléments électroluminescents de dimensions submillimétriques dans une source lumineuse permet d'une part d'alimenter potentiellement ces éléments de manière individuelle et leur petite taille permet d'autre part de réaliser des fonctions lumineuses pixellisées avec une résolution élevée, notamment une transition lumineuse dans le cadre d'une transition dans une zone de coupure d'un feu de croisement.

Selon un mode de réalisation, les éléments luminescents peuvent être des bâtonnets et/ou des plots électroluminescents de dimensions submillimétriques.

Une forme de bâtonnet permet d'augmenter la densité surfacique d'éléments électroluminescents et ainsi l'intensité lumineuse délivrée par la source lumineuse.

Selon un mode de réalisation de l'invention, l'ensemble d'éléments électroluminescents peut comprendre un premier ensemble d'éléments électroluminescents et un deuxième ensemble d'éléments électroluminescents, les éléments électroluminescents du premier ensemble peuvent être alimentés à une première valeur d'intensité électrique par un circuit de contrôle et au moins deux éléments électroluminescents du deuxième ensemble peuvent être alimentés par le circuit de contrôle à des valeurs respectives distinctes d'intensité lumineuse de manière à réaliser la transition.

Il est ainsi rendu possible de réaliser un gradient d'intensité lumineuse dans la deuxième zone en disposant de sous-ensembles d'éléments électroluminescents alimentés par des courants distincts.

En complément, l'alimentation électrique des éléments électroluminescents du deuxième ensemble peut être contrôlable par le circuit de contrôle de manière à modifier un gradient d'intensité lumineuse de la transition.

Le gradient d'intensité lumineuse de la transition n'est ainsi pas statique et peut être reconfiguré. Un même module d'émission lumineuse peut ainsi être utilisé dans plusieurs pays ayant des contraintes réglementaires différentes.

Encore en complément, le module d'émission lumineuse peut en outre comprendre une interface homme machine configurée pour piloter le circuit de contrôle de manière à modifier un gradient d'intensité lumineuse de la transition.

Ainsi, l'utilisateur, tel que le conducteur, peut lui-même modifier le gradient d'intensité lumineuse de la transition, en fonction, par exemple, du pays dans lequel il se trouve.

Selon un mode de réalisation, la deuxième zone comprend au moins une première sous-zone et une deuxième sous-zone distinctes l'une de l'autre, la première sous-zone étant plus proche de la première zone que la deuxième sous-zone, et dans lequel une première densité d'éléments électroluminescents dans la première sous-zone est supérieure à une deuxième densité d'éléments électroluminescents dans la deuxième sous-zone, de manière à assurer la transition entre la première intensité lumineuse et la deuxième intensité lumineuse.

Ainsi, de manière complémentaire de la variation du courant délivré aux éléments électroluminescents du deuxième ensemble, ou à titre d'alternative, l'invention prévoit de faire varier la densité d'éléments électroluminescents dans les différentes sous-zones. Lorsque ce mode de réalisation est une alternative, il permet de d'éviter d'employer un circuit de contrôle complexe, les éléments électroluminescents du deuxième ensemble pouvant être alimentés par le même courant, puisque la transition est réalisée par les différentes densités d'éléments électroluminescents.

Selon un mode de réalisation, les éléments électroluminescents peuvent en outre être répartis dans une troisième zone, la deuxième zone étant au moins partiellement située entre la première zone et la troisième zone, et la troisième zone peut émettre à une troisième intensité lumineuse égale ou inférieure à la deuxième intensité lumineuse.

La transition lumineuse est ainsi assurée entre deux zones. Par exemple, la troisième zone peut être sombre dans une configuration feu de croisement et allumée dans une configuration feu de route.

Un deuxième aspect de l'invention concerne un dispositif lumineux, notamment pour véhicule automobile, comprenant un module d'émission lumineuse selon le premier aspect de l'invention.

D'autres caractéristiques et avantages de l'invention apparaîtront à l'examen de la description détaillée ci-après, et des dessins annexés sur lesquels:
- la figure 1 illustre une source lumineuse selon l'art antérieur ;
- la figure 2 illustre des éléments électroluminescents d'une source lumineuse selon un mode de réalisation ;
- la figure 3 est une vue en coupe d'une source lumineuse d'un module lumineux selon un mode de réalisation ;
- la figure 4 présente un module lumineux selon un mode de réalisation de l'invention ;
- la figure 5 présente une source lumineuse d'un module lumineux selon un premier mode de réalisation de l'invention ;
- la figure 6 présente une source lumineuse d'un module lumineux selon un deuxième mode de réalisation de l'invention.

La présente invention tire parti de l'utilisation d'éléments électroluminescents de dimensions submillimétriques. En effet, ces éléments sont d'une part adressables potentiellement de manière individuelle et leur taille permet de réaliser des fonctions lumineuses pixellisées avec une résolution élevée.

A titre d'exemple, les éléments électroluminescents de dimensions submillimétriques peuvent être des bâtonnets électroluminescents de dimensions submillimétriques, comme illustrés en référence aux figures 2 et 3.

La figure 2 illustre un ensemble d'éléments électroluminescents selon un mode de réalisation de l'invention.

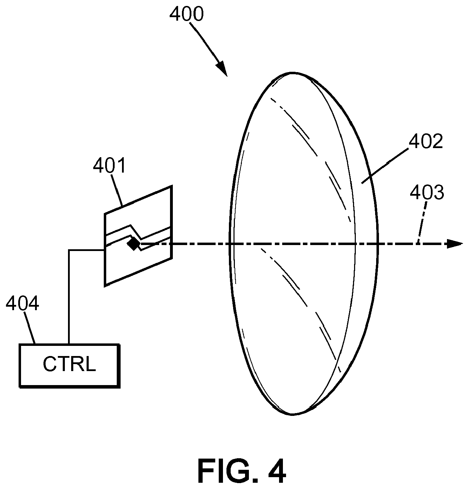

Sur la figure 4, à titre d'exemple, les éléments électroluminescents sont des bâtonnets électroluminescents 8 de dimensions submillimétriques, que l'on appellera par la suite bâtonnets électroluminescents. Ces bâtonnets électroluminescents 8 prennent naissance sur un même substrat 10. Chaque bâtonnet électroluminescent 8, ici formé par utilisation de nitrure de gallium GaN, s'étend perpendiculairement, ou sensiblement perpendiculairement, en saillie de substrat 10, ici réalisé à base de silicium, d'autres matériaux comme du carbure de silicium pouvant être utilisés pour le substrat sans sortir du contexte de l'invention. A titre d'exemple, les bâtonnets électroluminescents 8 pourraient être réalisés à partir d'un composé à base de nitrure d'aluminium et de nitrure de gallium AlN/GaN, ou à partir d'un composé à base d'aluminium, d'indium et de gallium AlN/GaN/InGaN.

Sur la figure 2, le substrat 10 présente une face inférieure 12, sur laquelle est rapportée une première électrode 14, et une face supérieure 16, en saillie de laquelle s'étendent les bâtonnets électroluminescents 8 et sur laquelle est rapportée une deuxième électrode 18.

A noter qu'un seul sous-ensemble de bâtonnets électroluminescents 8 est représenté sur la figure 4, et que la source électroluminescente selon l'invention comprend plusieurs sous-ensembles comme détaillé dans ce qui suit.

En particulier, comme détaillé ultérieurement, l'ensemble d'éléments électroluminescents peut comprendre au moins un premier ensemble et un deuxième ensemble, le deuxième ensemble pouvant comprendre plusieurs sous-ensembles d'au moins un élément électroluminescent. Dans ce cas, une ou des électrodes 14 et 18 peuvent être dédiées à un même sous-ensemble, de manière à ce que chaque sous-ensemble puisse être alimenté individuellement, c'est-à-dire indépendamment des autres sous-ensembles.

Différentes couches de matériaux peuvent être superposées sur la face supérieure 16, notamment après la croissance des bâtonnets électroluminescents depuis le substrat.

Parmi ces différentes couches, on peut trouver au moins une couche de matériau conducteur électriquement, afin de permettre l'alimentation électrique des bâtonnets électroluminescents 8. Cette couche est gravée de manière à relier les bâtonnets de chaque sous-ensemble adressable individuellement entre eux.

Les bâtonnets électroluminescents 8 de dimensions submillimétriques s'étirent depuis le substrat 10 et comportent, tel que cela est visible sur la figure 2, chacun un noyau 19 en nitrure de gallium, autour duquel sont disposés des puits quantiques 20 formés par une superposition radiale de couches de matériaux différents, ici du nitrure de gallium et du nitrure de gallium-indium, et une coque 21 entourant les puits quantiques également réalisée en nitrure de gallium.

Chaque bâtonnet s'étend selon un axe longitudinal 22 définissant sa hauteur, la base 23 de chaque bâtonnet étant disposée dans un plan 24 de la face supérieure 16 du substrat 10.

Les bâtonnets électroluminescents 8 peuvent présenter avantageusement la même forme. Ces bâtonnets électroluminescents 8 sont chacun délimité par une face terminale 26 et par une paroi circonférentielle 28 qui s'étend le long de l'axe longitudinal. Lorsque les bâtonnets électroluminescents 8 sont dopés et font l'objet d'une polarisation, la lumière résultante en sortie de la source lumineuse 100 est émise principalement à partir de la paroi circonférentielle 28, étant entendu que l'on peut prévoir que des rayons lumineux sortent également, au moins en petite quantité, à partir de la face terminale 26. Il en résulte que chaque bâtonnet électroluminescent 8 agit comme une unique diode électroluminescente et que la densité des bâtonnets électroluminescents 8 améliore la luminance de la source lumineuse 100.

La paroi circonférentielle 28 d'un bâtonnet électroluminescent 8, correspondant à la coquille de nitrure de gallium, peut être recouverte par une couche d'oxyde conducteur transparent TCO 29 qui forme l'anode de chaque bâtonnet électroluminescent complémentaire à la cathode formée par le substrat.

Cette paroi circonférentielle 28 peut s'étendre le long de l'axe longitudinal 22 depuis le substrat 10 jusqu'à la face terminale 26, la distance de la face terminale 26 à la face supérieure 16 du substrat, depuis laquelle prennent naissance les bâtonnets électroluminescents 8, définissant la hauteur de chaque bâtonnet électroluminescent 8. A titre d'exemple, on peut prévoir que la hauteur d'un bâtonnet électroluminescent 8 est comprise entre 1 et 10 micromètres, tandis que l'on peut prévoir que la plus grande dimension transversale de la face terminale, perpendiculairement à l'axe longitudinal 22 du bâtonnet électroluminescent concerné, soit inférieure à 2 micromètres.

On peut également prévoir de définir la surface d'un bâtonnet électroluminescent 8, dans un plan de coupe perpendiculaire à cet axe longitudinal 22, dans une plage de valeurs déterminée, et notamment entre 1,96 et 4 micromètres carré.

Ces dimensions, données à titre d'exemple non limitatif, permettent de démarquer une source de lumière 100 comprenant des éléments électroluminescents de dimensions submillimétriques, d'une source de lumière à diodes électroluminescentes planes.

On pourra également prévoir d'autres dimensionnements particuliers de la source lumineuse 100 selon l'invention, et notamment une dimension de la surface éclairante par exemple d'au plus 10 x 10 mm². La densité des bâtonnets électroluminescents 8 et la superficie de la surface éclairante peuvent en outre être calculées pour que la luminance obtenue par la pluralité de bâtonnets électroluminescents soit par exemple d'au moins 60 Cd/mm². Un mode de réalisation de l'invention repose notamment sur une densité variable d'éléments électroluminescents, comme détaillé dans ce qui suit.

La hauteur des bâtonnets électroluminescents 8 peut également être modifiée au sein de la source lumineuse 100, de sorte que certains bâtonnets électroluminescents peuvent avoir une hauteur différente d'autres bâtonnets électroluminescents.

La forme des bâtonnets électroluminescents 8 peut également varier, notamment sur la section des bâtonnets et sur la forme de la face terminale 26. Il a été illustré, sur la figure 2, des bâtonnets électroluminescents présentant une forme générale cylindrique, et notamment de section polygonale, ici plus particulièrement hexagonale. On comprend qu'il importe que la lumière puisse être émise à travers la paroi circonférentielle, que celle-ci présente une forme polygonale ou circulaire par exemple.

Par ailleurs, la face terminale 26 peut présenter une forme sensiblement plane et perpendiculaire à la paroi circonférentielle, de sorte qu'elle s'étend sensiblement parallèlement à la face supérieure 16 du substrat 10, tel que cela est illustré sur la figure 2, ou bien elle peut présenter une forme bombée ou en pointe en son centre, de manière à multiplier les directions d'émission de la lumière sortant de cette face terminale, tel que cela est illustré sur la figure 3.

Sur la figure 3, les bâtonnets électroluminescents 8 sont agencés en matrice à deux dimensions constituant un sous-ensemble. Un tel sous-ensemble peut par exemple correspondre à un pixel de l'image projetée, et la source lumineuse 100 peut ainsi comprendre plusieurs sous-ensembles correspondant à des pixels respectifs. Un sous-ensemble comprend au moins un élément électroluminescent 8.

Cet agencement peut être tel que les bâtonnets électroluminescents sont agencés en quinconce. L'invention couvre d'autres répartitions des bâtonnets, avec notamment des densités de bâtonnets qui peuvent être variables d'un sous-ensemble à l'autre.

La source lumineuse 100 peut comprendre en outre, tel qu'illustré sur la figure 3, une couche 30 d'un matériau polymère dans laquelle des bâtonnets électroluminescents 8 sont au moins partiellement noyés. La couche 30 peut ainsi s'étendre sur toute l'étendue du substrat ou seulement autour d'un sous-ensemble ou d'un ensemble uniquement.

Le matériau polymère, qui peut notamment être à base de silicone, permet de protéger les bâtonnets électroluminescents 8 sans gêner la diffusion des rayons lumineux.

Il est généralement possible d'intégrer dans cette couche 30 de matériau polymère des moyens de conversion de longueur d'onde, et par exemple des luminophores, aptes à absorber au moins une partie des rayons émis par l'un des bâtonnets électroluminescents 8 et à convertir au moins une partie de la lumière d'excitation absorbée en une lumière d'émission ayant une longueur d'onde différente de celle de la lumière d'excitation.

La source lumineuse 100 peut comporter en outre un revêtement 32 de matériau réfléchissant la lumière, qui est disposé entre les bâtonnets électroluminescents 8 pour dévier les rayons initialement orientés vers le substrat 10, vers la face terminale 26 des bâtonnets électroluminescents 8. En d'autres termes, la face supérieure 16 du substrat 10 peut comporter un moyen réfléchissant qui renvoie les rayons lumineux, initialement orientés vers la face supérieure 16, vers la face de sortie de la source lumineuse 100. On récupère ainsi des rayons qui autrement seraient perdus. Ce revêtement 32 peut être disposé entre les bâtonnets électroluminescents 8 sur la couche d'oxyde conducteur transparent 29.

La figure 4 présente un module d'émission lumineuse 400 selon un mode de réalisation de l'invention. Un tel module d'émission lumineuse peut être intégré dans un dispositif d'éclairage/signalisation, tel qu'un phare, notamment dans un véhicule automobile.

Le module d'émission lumineuse comprend une source lumineuse 401 comprenant un ensemble d'éléments électroluminescents de dimensions submillimétriques. Selon l'invention, les éléments électroluminescents 8 sont répartis dans une première zone et dans une deuxième zone de la source lumineuse, de manière à ce que la première zone émette une première intensité lumineuse et à ce que la deuxième zone assure une transition entre la première intensité lumineuse à proximité de la première zone et une deuxième intensité lumineuse inférieure à la première intensité lumineuse.

La première zone en question peut correspondre à la zone 101 de l'art antérieur illustré sur la figure 1. Toutefois, l'invention prévoit en outre une zone de transition afin de diminuer progressivement l'intensité lumineuse à partir de l'intensité de la première zone. Par exemple, l'intensité lumineuse peut être diminuée jusqu'à la deuxième intensité lumineuse pouvant correspondre à une intensité lumineuse maximale d'une troisième zone pouvant correspondre à la zone 102 de l'art antérieur illustré sur la figure 1. L'ajout d'une troisième zone est optionnel selon l'invention.

Par exemple, le rapport R entre la première intensité lumineuse et la deuxième intensité lumineuse, ou gradient d'intensité lumineuse, peut être fixé ou ajusté en fonction de contraires réglementaires.

Par exemple, en Europe, des contraintes réglementaires imposent que R soit au minimum égal à 16,2. Aux Etats-Unis, des contraintes réglementaires imposent que R soit compris entre 10,8 et 88,9.

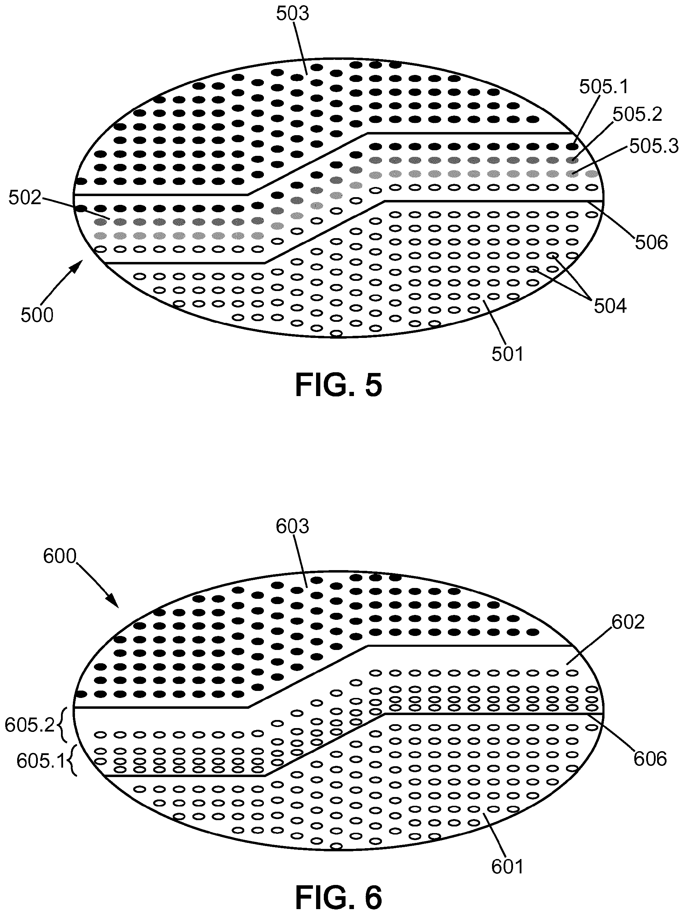

La répartition des éléments électroluminescents de dimensions submillimétriques permet de réaliser une telle transition. Deux modes de réalisation de la répartition des éléments électroluminescents sont décrits en référence aux figures 5 et 6.

Le module d'émission lumineuse 400 peut en outre comprendre une optique de mise en forme permettant de focaliser les rayons lumineux issus de la source lumineuse 401 dans le sens d'un axe optique 403. Le module d'émission lumineuse peut en outre comprendre un circuit de contrôle 404, qui est décrit dans ce qui suit.

La figure 5 présente une source lumineuse 500 d'un module d'émission lumineuse selon un premier mode de réalisation de l'invention.

Selon le premier mode de réalisation, la source lumineuse 500 comprend un premier ensemble et un deuxième ensemble d'éléments électroluminescents, répartis dans une première zone 501 et une deuxième zone 502. A titre illustratif, un troisième ensemble d'éléments électroluminescents peuvent être dans une troisième zone 503, comme illustré sur la figure 5.

Dans le premier mode de réalisation, les premier et deuxième ensembles sont répartis dans des zones respectives distinctes, délimitées par la limite 506. Les éléments électroluminescents du premier ensemble sont ainsi inclus dans la première zone 501 et les éléments électroluminescents du deuxième ensemble sont inclus dans la deuxième zone 502, la première zone et la deuxième zone étant séparées par la limite 506. L'invention peut toutefois prévoir qu'au moins certains éléments électroluminescents du premier et du deuxième ensemble soient entremêlées, c'est-à-dire qu'il existe que l'intersection de la première zone 501 et de la deuxième zone 502 n'est pas un ensemble nul.

Le premier ensemble comprend les éléments électroluminescents 504 répartis dans la première zone 501. Les éléments électroluminescents 504 sont configurés et alimentés de manière à ce que la première zone émette à la première intensité lumineuse. Dans le cas où l'intensité lumineuse varie au sein de la première zone, la première intensité lumineuse correspond préférentiellement à l'intensité lumineuse émise par les éléments électroluminescents de la première zone 501 à proximité de la limite 506.

Selon le premier mode de réalisation de l'invention, les éléments électroluminescents du deuxième ensemble sont alimentés à des valeurs respectives distinctes d'intensité lumineuse de manière à réaliser la transition entre la première intensité lumineuse et la deuxième intensité lumineuse.

A cet effet, les éléments électroluminescents du deuxième ensemble peuvent être répartis en différents sous-ensembles d'au moins un élément électroluminescent, chaque sous-ensemble étant adressable individuellement, c'est à dire que les sous-ensembles d'éléments électroluminescents sont alimentés indépendamment les uns des autres.

Par exemple, l'élément électroluminescent 505.1 et l'élément électroluminescent 505.2 peuvent appartenir à deux sous-ensembles distincts et peuvent ainsi être alimentés indépendamment. Ainsi, l'élément électroluminescent 505.1, étant plus distant de la limite 506 que l'élément 505.2, peut émettre à une intensité lumineuse inférieure à l'intensité lumineuse émise par l'élément électroluminescent 505.2. Par exemple, l'élément électroluminescent 505.1 étant situé à la limite avec le troisième ensemble 503, l'élément électroluminescent 505.1 peut émettre à la deuxième intensité lumineuse.

En outre, l'élément électroluminescent 505.3 peut appartenir à un troisième sous-ensemble. Etant situé à proximité de la limite 506, l'élément électroluminescent 505.3 peut émettre à la première intensité lumineuse.

Selon une réalisation complémentaire, les intensités lumineuses respectives émises par les différents sous-ensembles d'éléments électroluminescents du deuxième ensemble peuvent être contrôlées et modifiées par le circuit de contrôle 404. Cela permet ainsi de réaliser des transitions différentes, aussi appelées « flous de coupure », plus ou moins progressives, entre la première intensité lumineuse et la deuxième intensité lumineuse. Par exemple, la transition peut être adaptée lorsque le véhicule automobile transite dans un pays ayant des contraintes réglementaires en termes d'éclairage différentes.

Le circuit de contrôle 404 peut par exemple être piloté par une interface homme machine, non représentée sur les figures, et accessible par le conducteur du véhicule automobile. Le conducteur peut ainsi régler la progressivité, ou gradient d'intensité, de la transition. Il peut à cet effet fixer une valeur de flou de coupure, par exemple en pourcentages, entre 0 et 100%. Une telle valeur est ensuite interprétée par le circuit de contrôle 404 afin de régler les courants d'alimentation des différents sous-ensembles du deuxième ensemble d'éléments électroluminescents.

Le circuit de contrôle 404 peut en outre être utilisé pour régler les courants d'alimentation des sous-ensembles du deuxième ensemble 502 dans un processus de calibrage du dispositif d'éclairage/signalisation.

Les courants d'alimentation délivrés peuvent par exemple suivre une loi affine décroissante en fonction de la distance à la limite 506 avec la première zone 501.

La figure 6 présente une source lumineuse 600 d'un module d'émission lumineuse selon un deuxième mode de réalisation de l'invention.

Comme pour le premier mode de réalisation, l'ensemble d'éléments électroluminescents comprend au moins un premier ensemble et un deuxième ensemble répartis dans une première zone 601 et une deuxième zone 602. En complément, et de manière optionnelle, la source lumineuse 600 peut comprendre un troisième ensemble d'éléments électroluminescents dans une troisième zone 603, comme précédemment expliqué pour le premier mode de réalisation.

Comme pour le premier mode de réalisation, les éléments électroluminescents du premier ensemble sont groupés dans la première zone et les éléments électroluminescents du deuxième ensemble sont groupés dans la deuxième zone 602, la première zone et la deuxième zone étant délimitées par une limite 606.

Comme expliqué précédemment, les éléments électroluminescents des premier et deuxième ensembles peuvent être entremêlés de manière à ce que les zones se recoupent.

A la différence du premier mode de réalisation, la transition entre la première intensité et la deuxième intensité est réalisée en répartissant les éléments électroluminescents du deuxième ensemble 602 de manière à faire varier la densité d'éléments électroluminescents. Par exemple, les éléments électroluminescents sont au moins groupés dans une première sous-zone 605.1 comprenant une première densité d'éléments, et dans une deuxième sous-zone 605.2 comprenant une deuxième densité d'éléments. La première sous-zone 605.1 étant plus proche de la première zone 601, la première densité d'éléments est supérieure à la deuxième densité d'éléments. Bien entendu, les éléments électroluminescents du deuxième ensemble peuvent être groupés dans plus de deux sous-zones, de manière à rendre la transition plus progressive.

Les éléments électroluminescents de la première sous-zone 605.1 et les éléments électroluminescents de la deuxième sous-zone 605.2 peuvent appartenir au même sous-ensemble, c'est-à-dire qu'ils sont alimentés par le même courant d'alimentation. Dans ce cas, seule la variation de la densité d'éléments détermine la résolution et le gradient de la transition entre la première intensité et la deuxième intensité.

En variante, les éléments de la première sous-zone 605.1 et les éléments électroluminescents de la deuxième sous-zone 605.2 peuvent appartenir à des sous-ensembles distincts, de manière à être alimentés indépendamment. Dans ce cas, la variation de la densité d'éléments et les différents courants d'alimentation des sous-ensembles d'éléments déterminent la résolution et le gradient de la transition entre la première intensité et la deuxième intensité. Selon cette variante, le deuxième mode de réalisation est ainsi combiné avec le premier mode de réalisation.

Bien entendu, l'invention n'est pas limitée aux modes de réalisation décrits précédemment et fournis uniquement à titre d'exemple. Elle englobe diverses modifications, formes alternatives et autres variantes que pourra envisager l'homme du métier dans le cadre de la présente invention et notamment toutes combinaisons des différents modes de réalisation décrits précédemment.

## Revendications

1. Module d'émission lumineuse (400) d'un dispositif d'éclairage/signalisation, notamment pour véhicule automobile, comprenant :
- au moins une source lumineuse (401 ; 500 ; 600) comprenant un ensemble d'éléments électroluminescents (8) de dimensions submillimétriques ;
les éléments électroluminescents étant répartis dans une première zone et dans une deuxième zone de manière à ce que la première zone (501 ; 601) émette une première intensité lumineuse et à ce que la deuxième zone (502 ; 602) assure une transition entre la première intensité lumineuse à proximité de la première zone, et une deuxième intensité lumineuse inférieure à la première intensité lumineuse.

2. Module d'émission lumineuse selon la revendication 1, dans lequel les éléments luminescents sont des bâtonnets électroluminescents (8) de dimensions submillimétriques.

3. Module d'émission lumineuse selon l'une des revendications 1 ou 2, dans lequel l'ensemble d'éléments électroluminescents comprend un premier ensemble d'électroluminescents et un deuxième ensemble d'éléments électroluminescents,
dans lequel les éléments électroluminescents (8) du premier ensemble sont alimentés à une première valeur d'intensité électrique par un circuit de contrôle (404) ; et
dans lequel au moins deux éléments électroluminescents du deuxième ensemble sont alimentés par le circuit de contrôle à des valeurs respectives distinctes d'intensité lumineuse de manière à réaliser ladite transition.

4. Module d'émission lumineuse selon la revendication 3, dans lequel l'alimentation électrique des éléments électroluminescents du deuxième ensemble (502 ; 602) est contrôlable par le circuit de contrôle (404) de manière à modifier un gradient d'intensité lumineuse de ladite transition.

5. Module d'émission lumineuse selon la revendication 4, comprenant en outre une interface homme machine configurée pour piloter le circuit de contrôle de manière à modifier un gradient d'intensité lumineuse de ladite transition.

6. Module d'émission lumineuse selon l'une des revendications précédentes, dans lequel la deuxième zone comprend au moins une première sous-zone (605.1) et une deuxième sous-zone (605.2) distinctes l'une de l'autre, la première sous-zone étant plus proche de la première zone que la deuxième sous-zone, et dans lequel une première densité d'éléments électroluminescents dans la première sous-zone est supérieure à une deuxième densité d'éléments électroluminescents dans la deuxième sous-zone, de manière à assurer la transition entre la première intensité lumineuse et la deuxième intensité lumineuse.

7. Module d'émission lumineuse selon l'une des revendications précédentes, dans lequel les éléments électroluminescents (8) sont en outre répartis dans une troisième zone (503 ; 603), ladite deuxième zone étant au moins partiellement située entre la première zone et la troisième zone,
dans lequel la troisième zone émet à une troisième intensité lumineuse égale ou inférieure à la deuxième intensité lumineuse.

8. Dispositif lumineux, notamment pour véhicule automobile, comprenant un module d'émission lumineuse (400) selon l'une des revendications précédentes.
